# EUROPÄISCHE PATENTSCHRIFT

(11) **EP 1 456 915 B1**
(45) Veröffentlichungstag und Bekanntmachung des Hinweises auf die Patenterteilung: **26.10.2005**
(21) Anmeldenummer: 02795034.4
(22) Anmeldetag: 17.12.2002
(51) Int. Cl.: H01S 3/091, H01S 3/0941, H01S 3/042

(54) **PUMPANORDNUNG ZUM TRANSVERSALEN PUMPEN EINES AKTIVEN MEDIUMS**
PUMP ARRANGEMENT FOR TRANSVERSALLY PUMPING AN ACTIVE MEDIUM
ENSEMBLE POMPE SERVANT A POMPER TRANSVERSALEMENT UN MILIEU ACTIF

(30) Priorität: 18.12.2001 DE 10164523
(43) Veröffentlichungstag der Anmeldung: 15.09.2004
(73) Patentinhaber: IBL Industrial Broad-Spectrum Laser AG, 13597 Berlin (DE)
(72) Erfinder: MASSMANN, Frank, 13597 Berlin (DE); VOSS, Heike, 10435 Berlin (DE)
(74) Vertreter: Gross, Felix
(86) Internationale Anmeldenummer: PCT/DE2002/004719
(87) Internationale Veröffentlichungsnummer: WO 2003/052889

(56) Entgegenhaltungen:
- EP-A- 0 798 827
- EP-A- 1 128 505
- US-A- 5 307 365
- US-A- 5 661 738
- US-A- 5 774 488
- US-A- 5 781 580
- FUJIKAWA S ET AL: "28% ELECTRICAL-EFFICIENCY OPERATION OF A DIODE-SIDE-PUMPED ND:YAG ROD LASER" OPTICS LETTERS, OPTICAL SOCIETY OF AMERICA, WASHINGTON, US, Bd. 26, Nr. 9, 1. Mai 2001 (2001-05-01), Seiten 602-604, XP001077235 ISSN: 0146-9592
- KOECHNER W: "HIGH ENERGY DIODE-PUMPED SOLID STATE LASERS" REZA KENKYU - REVIEW OF LASER ENGINEERING, REZA GAKKAI, OSAKA, JP, Bd. 19, Nr. 7, Juli 1991 (1991-07), Seiten 619-626, XP001008603 ISSN: 0387-0200
- JACKSON S D ET AL: "ENCAPSULATED ROD FOR EFFICIENT THERMAL MANAGEMENT IN DIODE-SIDE- PUMPED ND:YAG LASERS" APPLIED OPTICS, OPTICAL SOCIETY OF AMERICA,WASHINGTON, US, Bd. 35, Nr. 15, 20. Mai 1996 (1996-05-20), Seiten 2562-2565, XP000589855 ISSN: 0003-6935

## Beschreibung

Die Erfindung betrifft eine Pumpanordnung nach dem Oberbegriff des Anspruchs 1.

Es ist bekannt, dass aktive Medium eines Lasers mit Diodenlasern longitudinal oder transversal zu pumpen (siehe z.B. Eichler, Eichler; Laser - Bauformen, Strahlführung, Anwendungen, Springer, 3. Auflage, Seite 150). Dabei wird beim transversalen Pumpen eine Laserdiode seitlich vom aktiven Material angeordnet, so dass die Laserstrahlung seitlich in das aktive Medium eintritt. Aufgrund dieser Anordnung ist jedoch die Ausleuchtung des Inneren des aktiven Mediums nicht gleichmäßig.

Der vorliegenden Erfindung liegt die Aufgabe zugrunde, eine Pumpanordnung zum transversalen Pumpen zu schaffen, die das aktive Medium gleichförmig ausleuchtet.

Diese Aufgabe wird erfindungsgemäß durch eine Pumpanordnung mit den Merkmalen des Anspruchs 1 gelöst.

Erfindungsgemäß werden genau zwei Pumplichtquellen in einer Ebene senkrecht zur Längsachse des aktiven Mediums, insbesondere eines Laserstabes, angeordnet, wobei der Betrag des kleinsten Winkels zwischen den Mittelachsen der Pumplichtquellen kleiner als 180° ist. Somit werden zwei Pumplichtquellen verwendet, die sich in jedem Fall nicht genau gegenüberstehen; d.h. die Pumplichtquellen sind in einer Ebene winklig angeordnet. Durch diese transversale Pumpanordnung ist eine gleichmäßige Ausleuchtung des aktiven Mediums möglich.

Dabei ist es vorteilhaft, wenn der Winkel zwischen den Mittelachsen der Pumplichtquellen in einer Ebene 120° oder 90° beträgt.

Eine vorteilhafte Ausgestaltung der erfindungsgemäßen Pumpanordnung weist zwei Gruppen von Pumplichtquellen in unterschiedlichen Ebenen auf, wobei die Ebenen senkrecht zur Längsachse des aktiven Mediums, insbesondere eines Laserstabes angeordnet sind. Damit sind die Pumplichtquellen parallel über die Länge des aktiven Mediums verteilt, was zu einer besonders guten Ausleuchtung führt.

Mit Vorteil weist jede Gruppe von Pumplichtquellen zwei Pumplichtquellen aufweist.

Eine besonders vorteilhafte Ausleuchtung des aktiven Mediums ergibt sich, wenn die Mittelachsen der Pumplichtquellen in einer ersten Ebene gegenüber den Mittelachsen der Pumplichtquellen einer zweiten Ebene um einen Winkel verdreht um die Längsachse des aktiven Mediums, insbesondere des Laserstabes angeordnet sind. Somit sind Pumplichtquellen nicht nur entlang des aktiven Mediums angeordnet, sondern strahlen noch aus unterschiedlichen Richtungen auf das aktive Medium ein.

Besonders vorteilhaft ist es, wenn der Winkel, der die Verdrehung der Mittelachsen der Pumplichtquellen gegenüber der Längsachse des Laserstabes angibt, 180° beträgt.

In einer vorteilhaften Ausgestaltung ist mindestens eine Pumplichtquelle als Laserdiode ausgebildet. Auch ist es vorteilhaft, wenn eine Laserdiode linienförmige Laserstrahlung emittiert.

In einer weiteren vorteilhaften Ausgestaltung der erfindunsgemäßen Pumpanordnung ist die Pumplichtstrahlung durch mindestens ein Linsensystem, insbesondere ein Mikrolinsensystem für Laserdiodenstrahlung formbar.

Besonders vorteilhaft ist es, wenn die erfindungsgemäße Pumpanordnung ein Wasserkühlungssystem, insbesondere ein Flowtubesystem aufweist.

Vorteilhafterweise weist die Flowtube mindestens eine reflektierende Schicht, insbesondere aus Gold und / oder Silber auf.

Auch ist es vorteilhaft, wenn die reflektierende Schicht von mindestens einer wärmeleitenden Schicht umgeben ist.

Die Erfindung wird nachfolgend unter Bezugnahme auf die Figuren der Zeichnungen an mehreren Ausführungsbeispielen näher erläutert. Es zeigen:
- Fig. 1: eine perspektivische Ansicht einer Ausführungform der erfindungsgemäßen Pumpanordnung;
- Fig. 2: eine schematische Darstellung der Anordnung von Pumplichtquellen;
- Fig. 3: eine perspektivische Darstellung eines Mittelstückes einer Ausführungsform der erfindungsgemäßen Pumpanordnung;
- Fig. 4: eine perspektivische Ansicht einer Laserdiode als Pumplichtquelle;
- Fig. 5: eine perspektivische, schematische Ansicht einer Flowtube als Kühlsystem;
- Fig. 5a: eine Schnittansicht der Flowtube gemäß Fig. 5.

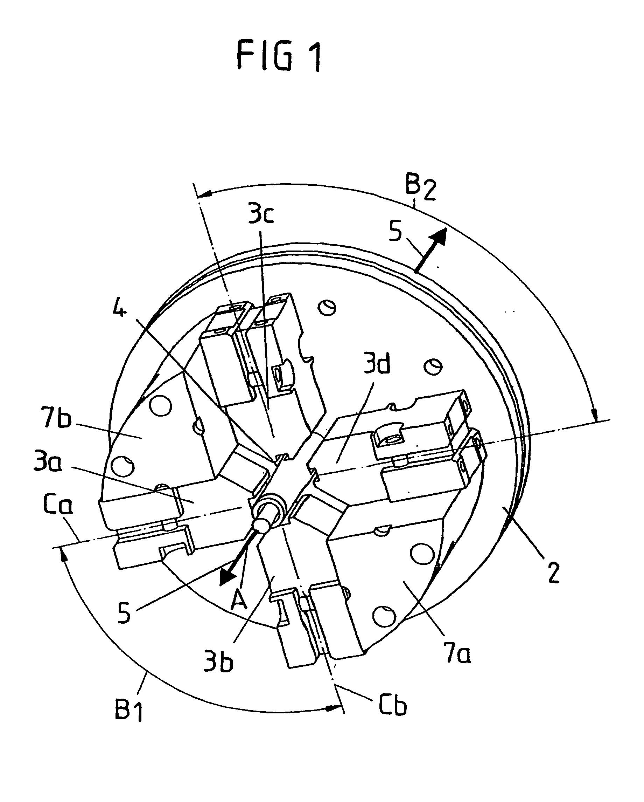

In Fig. 1 ist eine Ausführungsform einer Pumpanordnung dargestellt, die als Pumpkammer für einen Laserresonator oder als optischer Verstärker für Laserstrahlung verwendbar ist.

Die Pumpanordnung weist vier Pumplichtquellen 3a, 3b, 3c, 3d auf, die als kantenemittierende Laserdioden ausgebildet sind. Die Pumplichtquellen 3a, 3b, 3c, 3d sind um einen Laserstab 5 als aktives Medium herum angeordnet, so dass der Laserstab 5 transversal gepumpt werden kann. Die Strahlung im Laserstab 5, d.h. zwischen den Resonatorflächen, ist in Fig. 1 durch Pfeile angedeutet. Der Laserstab 5 weist eine Längsachse A auf.

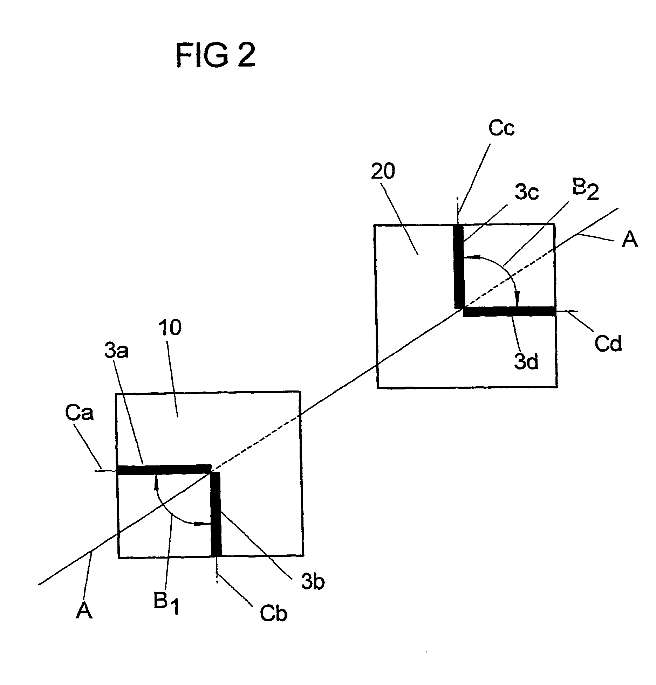

Die Pumplichtquellen 3a, 3b, 3c, 3d sind dabei in Gruppen in zwei verschiedenen Ebenen 10, 20 angeordnet (siehe insbesodnere Fig. 2), wobei die Ebenen 10, 20 senkrecht zur Längsachse A des Laserstab 5 stehen.

Die erste Gruppe der Pumplichtquellen 3a, 3b liegt in der Darstellung der Fig. 1 in der ersten, vorderen Ebene 10, die zweite Gruppe der Pumplichtquellen 3c, 3d, liegt in der Darstellung der Fig. 1 in der zweiten, hinteren Ebene 20.

Die Pumplichtquellen 3a, 3b, 3c, 3d sind in den jeweiligen Ebenen 10, 20 zueinander im rechten Winkel B₁, B₂ angeordnet. Grundsätzlich sind auch andere Winkel B in einer Ebene denkbar, so lange sich die Pumplichtquellen 3a, 3b, 3c, 3d in einer Ebene 10, 20 nicht diametral gegenüber stehen. In diesem diametralen Fall würde der Winkel genau 180° betragen. Erfindungsgemäß beträgt der Winkel B daher weniger als 180°.

Wie in Fig. 2 deutlicher zu sehen ist, sind die paarweise angeordneten Pumplichtquellen auch untereinander um einen bestimmten Winkel verdreht.

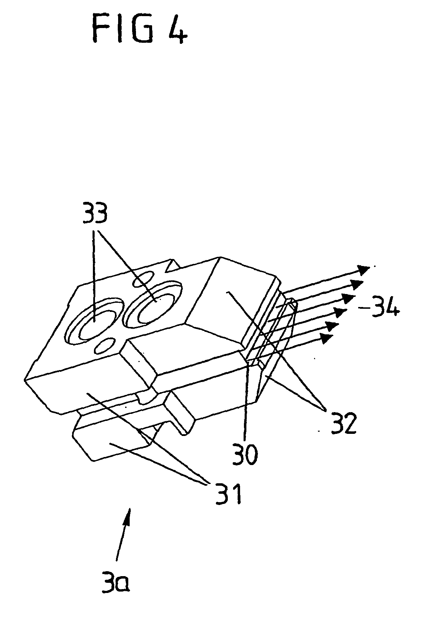

Die Pumplichtquellen 3a, 3b, 3c, 3d weisen an dem Ende, das zum Laserstab 5 zeigt eine keilförmige Ausbildung aus (siehe auch Fig. 4), damit die Pumplaserdioden möglichst nahe an den Laserstab 5 gebracht werden können. Der Laserstab kann hier Durchmesser bis zu 6 mm aufweisen. Die Pumplänge des Laserstabes 5 beträgt die doppelte Länge der hier baugleichen Pumplichtquellen 3a, 3b, 3c, 3d.

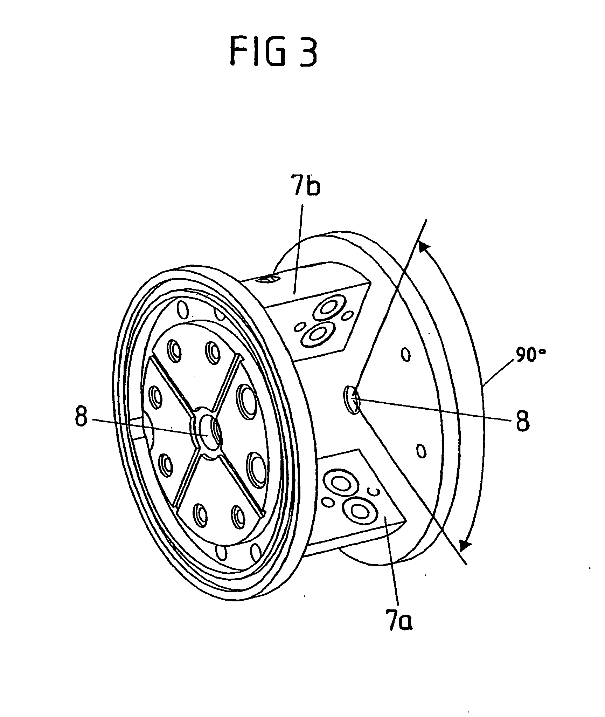

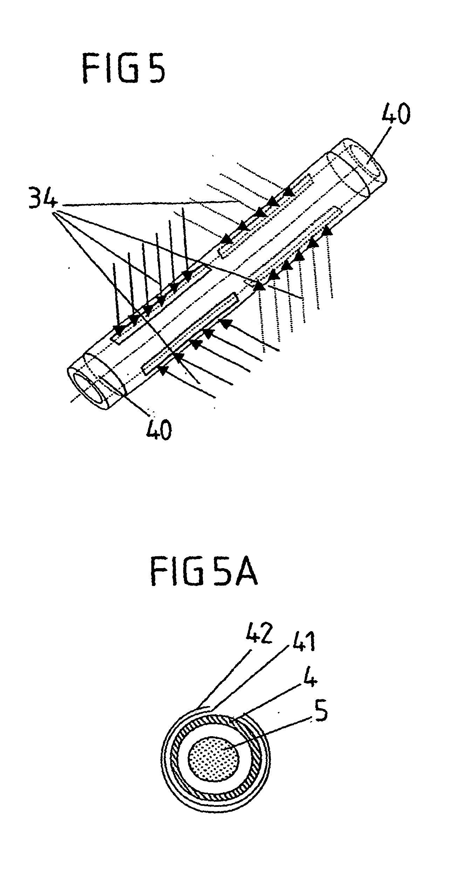

Die Pumplichtquellen 3a, 3b, 3c, 3d und der Laserstab 5 sind an einem Mittelstück 2 mit Speichen 7a, 7b (siehe Fig. 3) angeordnet. Um den Laserstab 5 ist eine Flowtube 4 als Kühlungssystem angeordnet, das in Zusammenhang mit Fig. 5 noch näher erläutert werden wird. In dem Mittelstück 2 sind Kanäle für die Kühlwasserversorgung der Pumplichtquellen 3a, 3b, 3c, 3d und des Laserstabes 5 angeordnet.

In der hier dargestellten Ausführungsform sind die Pumplichtquellen 3a, 3b, 3c, 3d alle baugleich ausgebildet. Alternativ können auch unterschiedliche Bauformen verwendet werden.

In Fig. 2 wird die Anordnung der Pumplichtquellen 3a, 3b, 3c, 3d in schematischer Weise dargestellt, um die geometrischen Verhältnisse darzustellen. Die Darstellung der Fig. 2 ist perspektivisch, wobei hier die Pumplichtquellen 3a, 3b, 3c, 3d hier nur durch Linien dargestellt sind.

Die Ebenen 10, 20 stehen senkrecht zur Längsachse des Laserstabes 5. Die erste Ebene 10 ist dabei in der Betrachtungsrichtung vor der zweiten Ebene 20 angeordnet. In der ersten Ebene 10 sind zwei Pumplichtquellen 3a, 3b untereinander im Winkel B₁=90° angeordnet. Dieser Winkel kann erfindungsgemäß zwischen (fast) 0° und weniger als 180° betragen.

In der zweiten Ebene sind zwei Pumplichtquellen 3c, 3d untereinander in einem Winkel von B₂=90° angeordnet. Auch dieser Winkel kann erfindungsgemäß zwischen (fast) 0° und weniger als 180° betragen.

Die Pumplichtquellen 3a, 3b der ersten Ebene 10 weisen jeweils Mittelachsen Ca, Cb auf. Die Pumplichtquellen 3c, 3d der zweiten Ebene weisen jeweils Mittelachsen Cc, Cd auf.

Die Mittelachsen Ca, Cb der Pumplichtquellen 3a, 3b in der ersten Ebene 10 sind gegenüber den Mittelachsen Cc, Cd der Pumplichtquellen 3c, 3d der zweiten Ebene (20) um einen Winkel von 180° um die Längsachse A des Laserstabes 5 verdreht angeordnet.

Mit dieser entlang der Längsachse A versetzten Anordnung lässt sich eine besonders gleichmäßige Ausleuchtung des Laserstabes 5 erreichen.

In Fig. 3 wird das Mittelstück 2 im Detail dargestellt, allerdings ohne die Pumplichtquellen 3a, 3b, 3c, 3d und ohne den Laserstab 5. Zentrisch sind die Öffnungen als Flowtubehalter 8 zu erkennen.

Das Mittelstück 2 besitzt zwei Speichen 7a, 7b, die zur Anordnung der Pumplichtquellen 3a, 3b, 3c, 3d dienen. Die Speichen sind untereinander im Winkel von 90° angeordnet. In den Speichen 7a, 7b sind Kanäle zur Wasserversorgung für die Kühlung angeordnet. Um die Laserdioden zu beströmen, geschieht die Kontaktierung mit einer mehrschichtigen Leiterplatte, die eine einfache Montage der Dioden erlaubt.

Wie in Fig. 1 zu erkennen ist, werden auf jeder der Speichen 7a, 7b zwei Laserdioden als Pumplichtquellen 3a, 3b, 3c, 3d angeordnet.

In Fig. 4 ist eine einzelne Pumplichtquelle 3a dargestellt, die zum Einbau in die erfindungsgemäße Pumpanordnung ausgebildet ist. Ein Diodenlaserbarren 30 ist zwischen zwei Klemmbacken 31 angeordnet. Die Klemmbacken 31 sind an der Seite, die dem Laserstab 5 zugewandt ist, um 45° abgeschrägt.

Der Winkel kann alternativ auch kleiner als 45° sein. In die Klemmbacken 31 sind Anschlüsse 33 (Zu- und Ablauf) für die Wasserversorgung integriert. Die Diodenlaserstrahlung 34 kann durch hier nicht dargestellte Mikrolinsen geformt werden. Der breitere Backenteil dient der Befestigung an den Speichen 7a, 7b (siehe Fig. 1 und 3).

In Fig. 5 ist in schematischer, perspektivischer Weise eine Flowtube 4 als Kühlungssystem für den Laserstab 5 (hier nicht dargestellt) dargestellt.

Die Flowtube 4 ist mit verschiedenen Beschichtungen versehen (siehe Fig. 5a), die in den Bereichen entfernt wird, in den Diodenstrahlung 36 zum transversalen Pumpen in den Laserstab 5 eintritt. Die der Pumpstrahlung gegenüberliegende Seite können verspiegelt sein. An den Enden weist die Flowtube 4 jeweils unbeschichtete Dichtflächen 40 auf.

In Fig. 5a ist die Flowtube 4 im Querschnitt dargestellt. Der Laserstab 5 ist im Inneren der Flowtube angeordnet. Dieser wird von der eigentlichen Flowtube 4 umgeben. Die Flowtube 4 ist an ihrer nach außen zeigenden Oberfläche mit einer reflektierenden Schicht 41 versehen. Wenn diese reflektierende Schicht 41 keine ausreichenden Wärmeleitfähigkeit besitzt, so kann diese (wie hier dargestellt) von einer wärmeleitfähigen Schicht 42 (z.B. Kupfer, Nickel) umgeben sein, um damit durch Restabsorption entstehende Wärme durch das Kühlmedium abzuführen.

Die Erfindung beschränkt sich in ihrer Ausführung nicht auf die vorstehend angegebenen bevorzugten Ausführungsbeispiele. Vielmehr ist eine Anzahl von Varianten denkbar, die von der erfindungsgemäßen Pumpanordnung auch bei grundsätzlich anders gearteten Ausführungen Gebrauch machen.

### Bezugszeichenliste

- 1: Pumpkammer
- 2: Mittelstück
- 3: Pumplichtquelle (Laserdioden 3a, 3b, 3c, 3d)
- 4: Kühlungssystem (Flowtube9
- 5: Laserstab
- 6: Endstücke
- 7a,: 7b Speichen
- 8: Flowtubehalter

- 10: erste Ebene
- 20: zweite Ebene

- 30: Diodenlaserbarren
- 31: Klemmbacken
- 32: Schrägen
- 33: Wasserzu- und -ablauf.
- 34: Diodenstrahlung

- 40: Dichtflächen
- 41: reflektierende Schicht
- 42: wärmeleitende Schicht

- A: Längsachse des Laserstabes
- B: Winkel zwischen zwei Pumplichtquellen in einer Ebene
- C: Mittelachsen der Pumplichtquellen

## Patentansprüche

1. Pumpanordnung zum transversalen Pumpen eines aktiven Mediums, insbesondere eines Laserstabes, bei der Pumplichtquellen in einer Ebene senkrecht zur Längsachse des aktiven Mediums, insbesondere eines Laserstabes, angeordnet sind, wobei der Betrag des kleinsten Winkels zwischen den Mittelachsen der Pumplichtquellen kleiner als 180° ist und mindestens zwei Gruppen von Pumplichtquellen in unterschiedlichen Ebenen angeordnet sind, wobei die Ebenen senkrecht zur Längsachse des aktiven Mediums, insbesondere des Laserstabes angeordnet sind,
**dadurch gekennzeichnet, dass**
jede Gruppe von Pumplichtquellen (3a, 3b, 3c, 3d) genau zwei Pumplichtquellen aufweist.

2. Pumpanordnung nach Anspruch 1, **dadurch gekennzeichnet, dass** der Winkel (B) zwischen den Mittelachsen (Ca, Cb) der Pumplichtquellen (3a, 3b) 120° oder 90° ist.

3. Pumpanordnung nach Anspruch 1, **dadurch gekennzeichnet, dass** die Mittelachsen (Ca, Cb) der Pumplichtquellen (3a, 3b) in einer ersten Ebene (10) gegenüber den Mittelachsen (Cc, Cd) der Pumplichtquellen (3c, 3d) einer zweiten Ebene (20) um einen Winkel verdreht um die Längsachse (A) des aktiven Mediums, insbesondere des Laserstabes (5) angeordnet sind.

4. Pumpanordnung nach Anspruch 3, **dadurch gekennzeichnet, dass** der Winkel, der die Verdrehung der Mittelachsen (Ca, Cb, Cc, Cd) der Pumplichtquellen (3a, 3b, 3c, 3d) gegenüber der Längsachse (A) des Laserstabes (5) angibt, 180° beträgt.

5. Pumpanordnung nach mindestens einem der vorhergehenden Ansprüche, **dadurch gekennzeichnet, dass** mindestens eine Pumplichtquelle (3a, 3b, 3c, 3d) als Laserdiode ausgebildet ist.

6. Pumpanordnung nach Anspruch 5, **dadurch gekennzeichnet, dass** mindestens eine Laserdiode (3a, 3b, 3c, 3d) linienförmige Laserstrahlung emittiert.

7. Pumpanordnung nach Anspruch 6, **dadurch gekennzeichnet, dass** die Pumplichtstrahlung durch mindestens ein Linsensystem, insbesondere ein Mikrolinsensystem für Laserdiodenstrahlung formbar ist.

8. Pumpanordnung nach mindestens einem der vorhergehenden Ansprüche, **gekennzeichnet durch** ein Wasserkühlungssystem (4), insbesondere ein Flowtubesystem ausgebildet ist.

9. Pumpanordnung nach Anspruch 8, **dadurch gekennzeichnet, dass** die Flowtube (4) mindestens eine reflektierende Schicht, insbesondere aus Gold und / oder Silber aufweist.

10. Pumpanordnung nach Anspruch 9, **dadurch gekennzeichnet, dass** die reflektierende Schicht von mindestens einer wärmeleitenden Schicht umgeben ist.

## Claims

1. Pump arrangement for the transversal pumping of an active medium, in particular of a laser rod, in which two pump light sources are located in a plane perpendicular to the longitudinal axis of the active medium, in particular of a laser rod, whereby the size of the smallest angle between the center axes of the pump light sources is less than 180° and at least two groups of pump light sources are located in different planes, whereby the planes are oriented perpendicular to the longitudinal axis of the active medium, in particular of the laser rod,
**characterized by** the fact that
each group of pump light sources (3a, 3b, 3c, 3d) has two pump light sources.

2. Pump arrangement as claimed in Claim 1, **characterized by** the fact that the angle (B) between the center axes (Ca, Cb) of the pump light sources (3a, 3b) is 120° or 90°.

3. Pump arrangement as claimed in Claim 1, **characterized by** the fact that the center axes (Ca, Cb) of the pump light sources (3a, 3b) in a first plane (10) are rotated with respect to the center axes (Cc, Cd) of the pump light sources (3c, 3d) in a second plane (20) by an angle around the longitudinal axis (A) of the active medium, in particular of the laser rod (5).

4. Pump arrangement as claimed in Claim 3, **characterized by** the fact that the angle that describes the rotation of the center axes (Ca, Cb, Cc, Cd) of the pump light sources (3a, 3b, 3c, 3d) with respect to the longitudinal axis (A) of the laser rod (5) is 180°.

5. Pump arrangement as claimed in at least one of the preceding claims, **characterized by** the fact that at least one pump light source (3a, 3b, 3c, 3d) is realized in the form of a laser diode.

6. Pump arrangement as claimed in Claim 5, **characterized by** the fact that at least one laser diode (3a, 3b, 3c, 3d) emits linear laser radiation.

7. Pump arrangement as claimed in Claim 6, **characterized by** the fact that the pump light beam can be shaped by at least one lens system, in particular a micro lens system for laser diode radiation.

8. Pump arrangement as claimed in at least one of the preceding claims, **characterized by** a water cooling system (4), in particular a flow tube system.

9. Pump arrangement as claimed in Claim 8, **characterized by** the fact that the flowtube (4) has at least one reflective coating, in particular one made of gold and/or silver.

10. Pump arrangement as claimed in Claim 9, **characterized by** the fact that the reflective coating is surrounded by at least one thermally conductive coating.

## Revendications

1. Dispositif de pompage pour le pompage transversal d'un milieu actif, en particulier d'un barreau de laser, où des sources lumineuses de pompage sont disposées dans un plan perpendiculairement par rapport à l'axe longitudinal du milieu actif, en particulier d'un barreau de laser, le montant du plus petit angle entre les axes médians des sources lumineuses de pompage étant inférieur à 180° et au moins deux groupes de sources lumineuses de pompage étant disposés dans des plans différents, les plans étant disposés perpendiculairement par rapport à l'axe longitudinal du milieu actif, en particulier du barreau de laser,
**caractérisé en ce que**
chaque groupe de sources lumineuses de pompage (3a, 3b, 3c, 3d) comporte exactement deux sources lumineuses de pompage.

2. Dispositif de pompage selon la revendication 1, **caractérisé en ce que** l'angle (B) entre les axes médians (Ca, Cb) des sources lumineuses de pompage (3a, 3b) est de 120° ou de 90°.

3. Dispositif de pompage selon la revendication 1, **caractérisé en ce que**, dans un plan (10) les axes médians (Ca, Cb) des sources lumineuses de pompage (3a, 3b) sont disposés décalés d'un angle autour de l'axe longitudinal (A) du milieu actif, en particulier du barreau de laser (5), par rapport aux axes médians (Cc, Cd) des sources lumineuses de pompage (3c, 3d) d'un deuxième plan (20).

4. Dispositif de pompage selon la revendication 3, **caractérisé en ce que** l'angle qui indique la torsion des axes médians (Ca, Cb, Cc, Cd) des sources lumineuses de pompage (3a, 3b, 3c, 3d) par rapport à l'axe longitudinal (A) du barreau de laser (5) est de 180°.

5. Dispositif de pompage selon au moins une des revendications précédentes, **caractérisé en ce qu'**au moins une source lumineuse de pompage (3a, 3b, 3c, 3d) est réalisée comme diode laser.

6. Dispositif de pompage selon la revendication 5, **caractérisé en ce qu'**au moins une diode laser (3a, 3b, 3c, 3d) émet un rayonnement laser linéaire.

7. Dispositif de pompage selon la revendication 6, **caractérisé en ce que** le rayonnement de lumière de pompage est formable par au moins un système de lentilles, en particulier un système de microlentilles pour le rayonnement de diodes laser.

8. Dispositif de pompage selon au moins une des revendications précédentes, **caractérisé par** un système de refroidissement à l'eau (4), en particulier par un système à tube de flux.

9. Dispositif de pompage selon la revendication 8, **caractérisé en ce que** le tube de flux (4) comporte au moins une couche réfléchissante, en particulier en or et/ou en argent.

10. Dispositif de pompage selon la revendication 9, **caractérisé en ce que** la couche réfléchissante est entourée d'au moins une couche thermoconductrice.
